# EUROPEAN PATENT SPECIFICATION

(11) **EP 3 581 985 B1**
(45) Date of publication and mention of the grant of the patent: **20.09.2023**
(21) Application number: 19179479.1
(22) Date of filing: 11.06.2019
(51) Int. Cl.: G02B 27/01, G02B 3/00, G02B 5/04, H10K 50/858, H10K 59/122, H10K 59/173

(54) **DISPLAY APPARATUS AND HEAD-MOUNTED DISPLAY INCLUDING THE SAME**
ANZEIGEVORRICHTUNG UND KOPFMONTIERTE ANZEIGE DAMIT
DISPOSITIF D'AFFICHAGE ET VISIOCASQUE LE COMPRENANT

(30) Priority: 11.06.2018 KR 20180067046
(43) Date of publication of application: 18.12.2019
(73) Proprietor: LG Display Co., Ltd., SEOUL, 07336 (KR)
(72) Inventor: LIM, Hyeongjun, Paju-si Gyeonggi-do 10845 (KR); PARK, JiYeon, Paju-si Gyeonggi-do 10845 (KR); KIM, Taemin, Paju-si Gyeonggi-do 10845 (KR)
(74) Representative: Harden, Henry Simon

(56) References cited:
- EP-A1- 2 403 316
- WO-A1-2010/113737
- JP-A- H09 326 297
- US-A1- 2003 020 399
- US-A1- 2012 248 970
- US-A1- 2015 008 403

## Description

### CROSS-REFERENCE TO RELATED APPLICATIONS

This application claims the benefit of the Korean Patent Application No. 10-2018-0067046 filed on June 11, 2018.

### BACKGROUND

### Field

The present disclosure relates to a display apparatus for displaying an image and a head-mounted display (HMD).

### Discussion of the Related Art

With the advancement of information-oriented society, various requirements for display apparatuses for displaying an image are increasing. Therefore, various display apparatuses such as liquid crystal display (LCD) apparatuses, plasma display panels (PDPs), and organic light emitting display apparatuses are being used recently.

Organic light emitting display apparatuses are self-emitting display apparatuses and do not need a separate backlight. Therefore, in comparison with LCD apparatuses, the organic light emitting display apparatuses may be implemented to be lightweight and thin and to have low power consumption. Also, the organic light emitting display apparatuses are driven with a direct current (DC) low voltage, have a fast response time, and are low in manufacturing cost.

Recently, HMDs each including an organic light emitting display apparatus are being developed. The HMDs are glasses-type monitor devices for virtual reality (VR) or augmented reality (AR), which are worn in a glasses type or a helmet type and form a focal point at a distance close to eyes of a user. However, in HMDs having an ultra-high resolution, since an interval between pixels is very short, light emitted from each of the pixels travels to a color filter of an adjacent pixel, causing color mixture.

US 2012/248970 A1 discloses an organic EL device including a substrate, a first electrode layer formed on the substrate, an organic EL layer formed on the first electrode layer, and a second electrode layer formed on the organic EL layer. A distribution characteristic of light emitted from the first electrode layer into the substrate has a luminance in a direction of a first angle of 20 to 50 degrees measured with respect to an axis perpendicular to the substrate.

US 2015/008403 A1 discloses a light emitting apparatus including a substrate including a plurality of light emitting devices, wherein the substrate further includes a plurality of first members configured to diffuse light emitted from at least one of the light emitting devices, and a second member that is positioned between the first members, wherein the second member includes a light absorbing layer.

US 2003/020399 A1 discloses a microlens array for a light emitting device. The light emitting device includes a plurality of OLEDs, each OLED having a minimum planar dimension. The array includes a plurality of microlenses, each of which has a minimum planar dimension and a maximum planar dimension. The minimum planar dimensions of the microlenses are larger than the maximum wavelength of visible light emitted from the OLEDs. The maximum planar dimensions of the microlenses are smaller than the smallest minimum planar dimension of any of the OLEDs.

EP 2 403 316 Al discloses a substrate comprising a transparent substrate and a light-concentrating structural body layer, wherein the light-concentrating structural body layer includes a plurality of structural bodies having a conic shape or a hemispherical shape, with the bottom faces of the plurality of structural bodies having a conic shape or a hemispherical shape being located on the same plane.

JP H09 326297 A discloses (machine translation) a transparent electrode formed on the surface of an organic light emitting layer which excites and emits light by the bonding of electrons or positive holes on the inside by applying an electric field, a back plate formed on the back surface of the organic light emitting layer, and a micro- prism which refracts light emitted in the organic light emitting layer in the direction almost parallel to the normal line arranged to form a micro-prism element. When an electric field is applied to between the transparent electrode and the back plate and the organic light emitting layer emits light, light emitted in the organic light emitting layer passes through the transparent electrode as divergent light, and is incident in the micro-prism element, and the outgoing direction of light is restricted in the direction almost parallel to the normal line with the micro-prism of the micro-prism element, the refraction of light between adjacent pixels is prevented, and a clear image can be obtained.

### SUMMARY

An invention is set out in the independent claim. Preferred embodiments of the invention are set out in the dependent claims. The examples of the following description that are not covered by the appended claims are by way of example only.

Accordingly, the present disclosure is directed to providing a display apparatus and a head-mounted display (HMD) that substantially obviate one or more problems due to limitations and disadvantages of the related art.

An aspect of the present disclosure is directed to providing a display apparatus and an HMD including the same, which prevent mixing of colors.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these and other advantages and in accordance with the purpose of the disclosure, as embodied and broadly described herein, there is provided a display apparatus including a substrate including a plurality of pixels where the amount of light is the maximum in an angle of more than 0 degrees and an encapsulation layer provided to covering the plurality of pixels, the encapsulation layer including a plurality of light collecting structures each having a quadrangular horn shape or a quadrangular truncated-horn shape.

In another aspect of the present disclosure, there is provided a head-mounted display including a display panel, a lens array including a plurality of lenses for enlarging an image displayed by the display panel, and an accommodating case accommodating the display panel and the lens array, wherein the display panel includes a substrate including a plurality of pixels where the amount of light is the maximum in an angle of more than 0 degrees and an encapsulation layer provided to covering the plurality of pixels, the encapsulation layer including a plurality of light collecting structures each having a quadrangular horn shape or a quadrangular truncated-horn shape.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a perspective view illustrating a display apparatus according to an embodiment of the present disclosure;
FIG. 2 is a cross-sectional view illustrating an example taken along line I-I' of FIG. 1;
FIG. 3 is an enlarged view illustrating an example of a region A of FIG. 2;
FIG. 4 is an enlarged view illustrating another example of a region A of FIG. 2;
FIG. 5 is an enlarged view illustrating another example of a region A of FIG. 2;
FIG. 6 is a cross-sectional view illustrating a modified embodiment of FIG. 2;
FIG. 7A is a diagram showing a light distribution of a light source to which a micro-cavity structure is not applied;
FIG. 7B is a diagram showing a light distribution of a light source to which a micro-cavity structure is applied;
FIG. 7C is a diagram showing a light distribution of a light source according to an embodiment of the present disclosure;
FIG. 8A is a diagram showing a simulation result of the light source of FIG. 7A;
FIG. 8B is a diagram showing a simulation result of the light source of FIG. 7B;
FIG. 8C is a diagram showing a simulation result of the light source of FIG. 7C;
FIG. 9A is a diagram illustrating an example of a light collecting structure;
FIG. 9B is a diagram illustrating another example of a light collecting structure;
FIG. 10A is a diagram showing a simulation result of a light collecting structure having a hemispherical shape;
FIG. 10B is a diagram showing a simulation result of a light collecting structure having a quadrangular horn shape;
FIG. 11 is a flowchart illustrating a method of manufacturing a display apparatus according to an embodiment of the present disclosure;
FIGS. 12A to 12H are cross-sectional views illustrating a method of manufacturing a display apparatus according to an embodiment of the present disclosure;
FIG. 13A is an exemplary diagram illustrating an HMD to which a display apparatus according to an embodiment of the present disclosure is applied; and
FIG. 13B is an exemplary diagram illustrating an example of an accommodating case of FIG. 13A.

### DETAILED DESCRIPTION OF THE DISCLOSURE

Reference will now be made in detail to the exemplary embodiments of the present disclosure, examples of which are illustrated in the accompanying drawings. Wherever possible, the same reference numbers will be used throughout the drawings to refer to the same or like parts.

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted. In a case where 'comprise', 'have', and 'include' described in the present specification are used, another part may be added unless 'only~' is used. The terms of a singular form may include plural forms unless referred to the contrary.

In construing an element, the element is construed as including an error range although there is no explicit description.

In describing a position relationship, for example, when a position relation between two parts is described as 'on~', 'over~', 'under~', and 'next~', one or more other parts may be disposed between the two parts unless 'just' or 'direct' is used.

In describing a time relationship, for example, when the temporal order is described as 'after~', 'subsequent~', 'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

In describing elements of the present disclosure, the terms "first", "second", etc. may be used. The terms are merely for differentiating one element from another element, and the essence, sequence, order, or number of a corresponding element should not be limited by the terms. It will be understood that when an element or layer is described as being "connected", "coupled", or "adhered" to another element or layer, the element or layer can be directly connected or adhered to the other element or layer, but the other element or layer can be "disposed" between elements or layers, or elements or layers can be "connected", "coupled", or "adhered" to each other through the other element or layer.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in co-dependent relationship.

Hereinafter, embodiments of a display apparatus according to the present disclosure will be described in detail with reference to the accompanying drawings. In adding reference numerals to elements of each of the drawings, although the same elements are illustrated in other drawings, like reference numerals may refer to like elements.

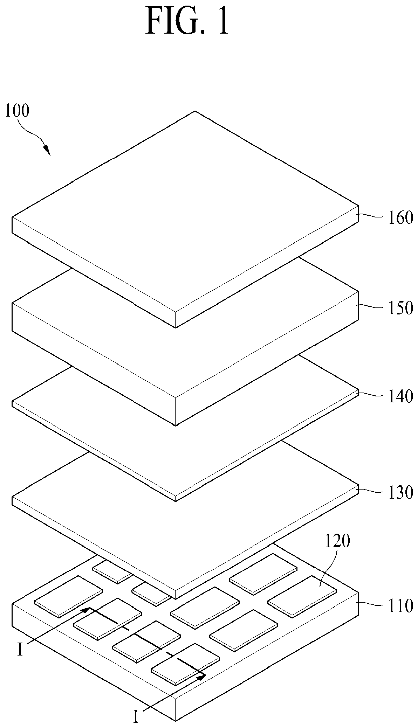

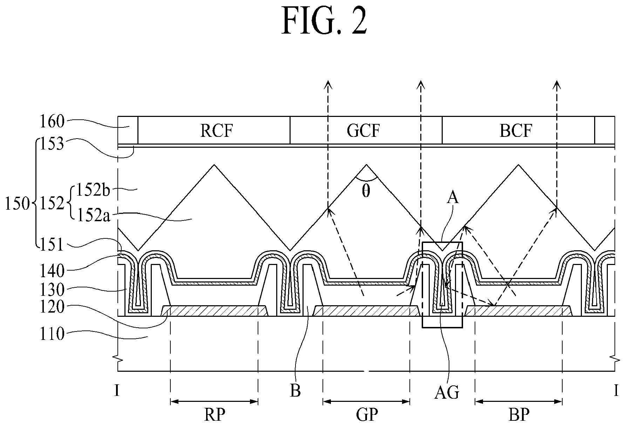

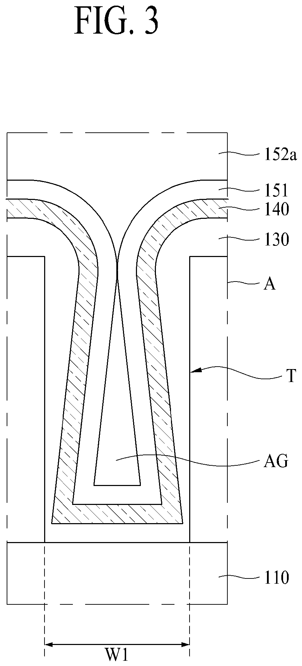

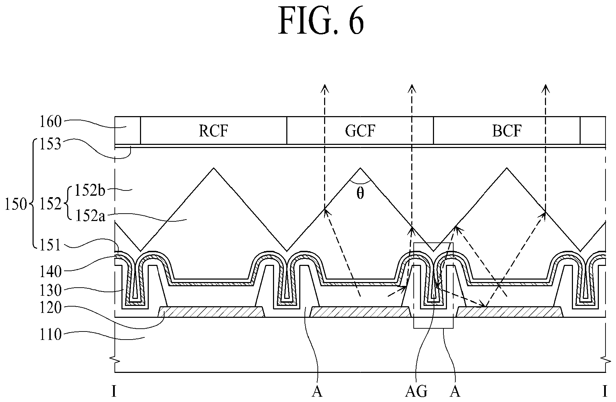

FIG. 1 is a perspective view illustrating a display apparatus 100 according to an embodiment of the present disclosure. FIG. 2 is a cross-sectional view illustrating an example taken along line I-I' of FIG. 1. FIGS. 3 to 5 are enlarged views illustrating various embodiments of a region A of FIG. 2. FIG. 6 is a cross-sectional view illustrating a modified embodiment of FIG. 2.

Referring to FIGS. 1 and 2, the display apparatus 100 according to an embodiment of the present disclosure may include a substrate 110, a plurality of first electrodes 120, an organic light emitting layer 130, a second electrode 140, a bank B, an encapsulation layer 150, and a color filter 160.

The substrate 110 may be a plastic film, a glass substrate, or a silicon wafer substrate which is formed through a semiconductor process. The substrate 110 may include a plurality of gate lines, a plurality of data lines, and a plurality of transistors. The gate lines and the data lines may be arranged to intersect one another. The gate lines may be connected to a gate driver and may be supplied with gate signals. The data lines may be connected to a data driver and may be supplied with data voltages.

An area where the first electrodes 120, the organic light emitting layer 130, and the second electrode 140 are sequentially stacked may be defined as a pixel which emits light. A pixel P may include a red pixel RP, a green pixel GP, and a blue pixel BP and may further include a white pixel.

The first electrodes 120 may be disposed apart from each other by a certain interval on the substrate 110, and thus, the pixel P may be divided by the first electrodes 120. N (where N is a positive integer) number of transistors may be provided in the pixel P, and when a gate signal is input through a gate line, the N transistors may provide a certain voltage to the first electrodes 120, based on a data voltage of a data line.

The first electrodes 120 may be provided on the substrate 110. For example, each of the first electrodes 120 may include a metal material, which is high in reflectance, such as a stacked structure (Ti/Al/Ti) of aluminum (Al) and titanium (Ti), a stacked structure (ITO/Al/ITO) of Al and indium tin oxide (ITO), an APC alloy, or a stacked structure (ITO/APC/ITO) of an APC alloy and ITO. The APC alloy may be an alloy of silver (Ag), palladium (Pd), and copper (Cu). Each of the first electrodes 120 may be an anode.

The bank B may be provided to cover an edge of the first electrode 120 on the substrate 110, for dividing a plurality of pixels P. The bank B may have a refractive index (for example, a refractive index of less than 1.7) which is less than that of the organic light emitting layer 130. A portion of light emitted from the organic light emitting layer 130 may be incident on the bank B. In this case, since a refractive index of the bank B is less than that of the organic light emitting layer 130, the light incident on the bank B may be totally reflected and may travel to the encapsulation layer 150.

Moreover, a trench T may be provided in the bank B, for providing an air gap AG. The trench T may be formed in a direction from an upper surface of the bank B to the first electrode 120 in the organic light emitting layer 130. The trench T according to an embodiment may be formed in a slit shape, but is not limited thereto and may be formed in another shape such as a cylindrical shape. The trench T may be provided in plurality, and the plurality of trenches T may be disposed apart from one another in the bank B.

The organic light emitting layer 130, the second electrode 140, and a first inorganic layer 151 configuring the encapsulation layer 150 may be sequentially stacked on the bank B, and as illustrated in FIG. 2, the air gap AG may be provided in the trench T.

In FIG. 2, the trench T is illustrated as being provided to pass through the bank B, but is not limited thereto. In another embodiment, as illustrated in FIG. 6, the trench T may be provided so that a portion of the bank B is recessed.

The bank B may be formed of an organic layer such as acryl resin, epoxy resin, phenolic resin, polyamide resin, polyimide resin, and/or the like.

The organic light emitting layer 130 may be provided on the first electrode 120 and the bank B. The organic light emitting layer 130 may include a hole transporting layer, a light emitting layer, and an electron transporting layer. In this case, when a voltage is applied to the first electrode 120 and the second electrode 140, a hole and an electron move to the light emitting layer through the hole transporting layer and the electron transporting layer and are combined in the light emitting layer to emit light.

The organic light emitting layer 130 may be a white light emitting layer which emits white light. In this case, the organic light emitting layer 130 may be a common layer which is provided in the pixels P in common. A layer provided in common may mean that the layer is continuous.

When the organic light emitting layer 130 is a white light emitting layer, the organic light emitting layer 130 may be provided in a tandem structure of two or more stacks. Each of the stacks may include a hole transporting layer, at least one light emitting layer, and an electron transporting layer.

Moreover, a charge generating layer may be provided between adjacent stacks. The charge generating layer may include an n-type charge generating layer, disposed adjacent to a lower stack, and a p-type charge generating layer which is provided on the n-type charge generating layer and is disposed adjacent to an upper stack. The n-type charge generating layer may inject an electron into the lower stack, and the p-type charge generating layer may inject a hole into the upper stack. The n-type charge generating layer may be formed of an organic layer doped with alkali metal such as lithium (Li), sodium (Na), potassium (K), or cesium (Cs) or alkali earth metal such as magnesium (Mg), strontium (Sr), barium (Ba), or radium (Ra). The p-type charge generating layer may be formed by doping a dopant on an organic material having an ability to transport holes.

The organic light emitting layer 130 may also be provided on the trench T provided in the bank B. The organic light emitting layer 130 may be formed through a deposition process or a solution process. In a case where the organic light emitting layer 130 is formed through the deposition process, the organic light emitting layer 130 may be formed by using an evaporation process. A layer formed through the evaporation process may not be good in step coverage characteristic. Since the organic light emitting layer 130 is not good in step coverage characteristic, the organic light emitting layer 130 may be formed not to have a constant thickness in a region where a step height occurs due to the trench T provided in the bank B.

The organic light emitting layer 130 may be formed thickly in a portion which is bent from an upper surface of the bank B to a side surface of the trench T. In more detail, a thickness of the organic light emitting layer 130 in a boundary portion between the upper surface of the bank B and a first side surface of the trench T may be set to be thicker than that of the organic light emitting layer 130 in the first side surface or a floor of the trench T. Also, a thickness of the organic light emitting layer 130 in a boundary portion between the upper surface of the bank B and a second side surface of the trench T may be set to be thicker than that of the organic light emitting layer 130 in the second side surface or the floor of the trench T. The first side surface and the second side surface of the trench T may face each other. As a result, an inner portion of the trench T may be narrowed in a direction from a lower portion to an upper portion thereof, and the second electrode 140 and the encapsulation layer 150 may be provided on the organic light emitting layer 130, thereby providing the air gap AG.

Moreover, a thickness of the organic light emitting layer 130 in a sidewall of the trench T provided in the bank B may be set to be thinner than that of the organic light emitting layer 130 in the floor of the trench T. In an embodiment of the present disclosure, since the trench T which passes through the bank B or is recessed is provided, a length of a current leakage path passing through the organic light emitting layer 130 between adjacent pixels P may be longer than a case where there is no trench T. Also, in an embodiment of the present disclosure, since a thickness of the organic light emitting layer 130 in a sidewall of the trench T provided in the bank B is set to be thinner than that of the organic light emitting layer 130 in the floor of the trench T, a resistance of the organic light emitting layer 130 may increase, and thus, an influence of leakage of a current through the organic light emitting layer 130 may be minimized on an adjacent pixel.

The second electrode 140 may be provided on the organic light emitting layer 130. The second electrode 140 may be a common layer which is provided in the pixels P in common. The second electrode 140 may be formed of a transparent conductive material (or TCO), such as indium tin oxide (ITO) or indium zinc oxide (IZO), or a semi-transmissive conductive material such as magnesium (Mg), silver (Ag), or an alloy of Mg and Ag.

The second electrode 140 may be provided on the trench T provided in the bank B. The second electrode 140 may be formed through a physics vapor deposition (PVD) process such as a sputtering process. A layer formed through the PVD process such as the sputtering process may be good in step coverage characteristic. Therefore, despite a step height being caused by the trench T provided in the bank B, the second electrode 140 may be deposited on the sidewall and the floor of the trench T to have a uniform thickness compared to the organic light emitting layer 130.

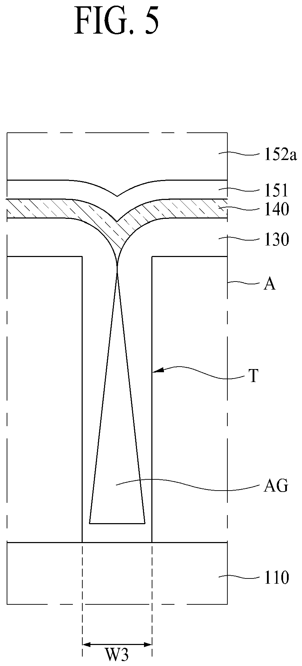

In FIGS. 2 and 3, the second electrode 140 is illustrated as being deposited on the sidewall and the floor of the second electrode 140, but is not limited thereto. In another embodiment, as illustrated in FIG. 5, the second electrode 140 may be provided in only the air gap AG. The organic light emitting layer 130 may be first formed on the trench T. In this case, since the organic light emitting layer 130 is not good in step coverage characteristic, the organic light emitting layer 130 may be formed not to have a constant thickness, and particularly, the organic light emitting layer 130 may be formed thickly in a boundary portion between the upper surface of the bank B and the side surface of the trench T. In this case, the air gap AG may be formed in the trench T so as to be narrowed in a direction from a lower portion to an upper portion thereof due to the organic light emitting layer 130. Therefore, the second electrode 140 provided on the organic light emitting layer 130 may not be deposited on the sidewall and the floor of the trench T and may be deposited in only the air gap AG.

The encapsulation layer 150 may be provided to cover the second electrode 140. The encapsulation layer 150 may prevent oxygen or water from penetrating into the organic light emitting layer 130 and the second electrode 140. To this end, the encapsulation layer 150 includes at least one inorganic layer and at least one organic layer.

In detail, the encapsulation layer 150 includes the first inorganic layer 151 and an organic layer 152. According to the claimed invention, the encapsulation layer 150 further includes a second inorganic layer 153.

The first inorganic layer 151 may be provided to cover the second electrode 140. The organic layer 152 is provided on the first inorganic layer 151, and particles may be provided to have a length which is sufficient for preventing particles from penetrating into the organic light emitting layer 130 and the second electrode 140 via the first inorganic layer 151. The second inorganic layer 153 is provided to cover the organic layer 152.

Each of the first and second inorganic layers 151 and 153 may be formed of silicon nitride, aluminum nitride, zirconium nitride, titanium nitride, hafnium nitride, tantalum nitride, silicon oxide, aluminum oxide, or titanium oxide. Each of the first and second inorganic layers 151 and 153 may be deposited through a chemical vapor deposition (CVD) process or an atomic layer deposition (ALD) process, but is not limited thereto.

The first inorganic layer 151 may be provided on the sidewall and the floor of the trench T provided in the bank B. The first inorganic layer 151 may be provided on the sidewall and the floor of the trench T, and thus, the air gap AG may be provided in the trench T.

In FIGS. 2 and 3, the first inorganic layer 151 is illustrated as being deposited on the sidewall and the floor of the trench T, but is not limited thereto. In a case where the first inorganic layer 151 is formed through the CVD process, the first inorganic layer 151 may be formed not to have a constant thickness in the trench T. Particularly, the first inorganic layer 151 may be deposited thinly in the boundary portion between the sidewall and the floor of the trench T, and due to this, seam may occur. The seam occurring in the first inorganic layer 151 may be provide a path through which water penetrates into the second electrode 140 and the organic light emitting layer 130.

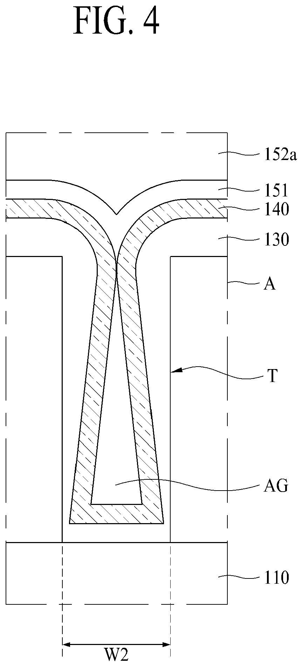

In another embodiment, as illustrated in FIGS. 4 and 5, the first inorganic layer 151 may be provided in only the air gap AG. In more detail, the organic light emitting layer 130 may be first provided on the trench T. In this case, since the organic light emitting layer 130 is not good in step coverage characteristic, the organic light emitting layer 130 may be formed not to have a constant thickness, and particularly, the organic light emitting layer 130 may be formed thickly in the boundary portion between the upper surface of the bank B and the side surface of the trench T. In this case, as illustrated in FIG. 5, the air gap AG may be formed in the trench T so as to be narrowed in a direction from a lower portion to an upper portion thereof due to the organic light emitting layer 130. Alternatively, as illustrated in FIG. 4, the air gap AG may be provided in the trench T so as to be narrowed in a direction from a lower portion to an upper portion thereof due to the organic light emitting layer 130 and the second electrode 140. Therefore, the first inorganic layer 151 provided on the organic light emitting layer 130 may not be deposited on the sidewall and the floor of the trench T and may be deposited in only the air gap AG. The first inorganic layer 151 formed in this manner may not be deposited in the trench T and may be deposited in only the air gap AG, thereby preventing the occurrence of seam.

The encapsulation layer 150 according to an embodiment of the present disclosure collects light emitted from each pixel P and may transfer the collected light to the color filter 160. To this end, the organic layer 152 configuring the encapsulation layer 150 includes a high refraction organic layer 152a and a low refraction organic layer 152b.

The high refraction organic layer 152a is provided on the first inorganic layer 151 to prevent particles from penetrating into the organic light emitting layer 130 and the second electrode 140 via the first inorganic layer 151 and to collect light emitted from the organic light emitting layer 130.

The high refraction organic layer 152a includes a plurality of light collecting structures, for collecting light incident from the organic light emitting layer 130. In this case, the plurality of light collecting structures may be disposed to correspond to the plurality of pixels P and may collect light incident from each pixel P. The light collecting structures have a quadrangular horn shape (also known as a rectangle-based pyramid or quadrangle-based pyramid) or a quadrangular truncated-horn shape (also known as a truncated rectangle-based pyramid or truncated quadrangle-based pyramid). A rectangle-based pyramid and truncated rectangle-based pyramid may also be a square-based pyramid and truncated square-based pyramid, respectively.

The high refraction organic layer 152a including the light collecting structures is formed of an organic material having a refractive index (for example, a refractive index of 1.7 or more) which is greater than that of the low refraction organic layer 152b.

Since the high refraction organic layer 152a has a refractive index which is greater than that of the low refraction organic layer 152b, a portion of light incident from the organic light emitting layer 130 is refracted and is transferred to the color filter 160. In more detail, the light emitted from the organic light emitting layer 130 may be incident on an interface between the high refraction organic layer 152a and the low refraction organic layer 152b. In this case, the light incident on the interface between the high refraction organic layer 152a and the low refraction organic layer 152b may be refracted when an incident angle thereof is equal to or greater than a certain angle. Refracted light may pass through the color filter 160 and may be discharged to the outside. That is, the light emitted from the organic light emitting layer 130 may be collected by the organic layer 152 including the light collecting structure.

Moreover, since the high refraction organic layer 152a has a refractive index which is greater than that of the low refraction organic layer 152b, a portion of the light incident from the organic light emitting layer 130 may be reflected. In more detail, the light emitted from the organic light emitting layer 130 may be incident on the interface between the high refraction organic layer 152a and the low refraction organic layer 152b. In this case, the light incident on the interface between the high refraction organic layer 152a and the low refraction organic layer 152b may be reflected when the incident angle thereof is less than the certain angle. Light reflected from the interface between the high refraction organic layer 152a and the low refraction organic layer 152b may be incident on the air gap AG as illustrated in FIG. 2. Light incident on the air gap AG may be reflected and may be incident on the first electrode 120 again. The light incident on the first electrode 120 may be reflected and may be incident on the interface between the high refraction organic layer 152a and the low refraction organic layer 152b again. In this case, the incident light may be refracted and may be transferred to the color filter 160.

The low refraction organic layer 152b may be provided on the high refraction organic layer 152a. The low refraction organic layer 152b may be provided to cover the high refraction organic layer 152a.

The low refraction organic layer 152b may be formed of an organic material having a refractive index (for example, a refractive index of less than 1.7) which is less than that of the high refraction organic layer 152a. For example, the low refraction organic layer 152b may be formed of a monomer.

The color filter 160 may be provided on the encapsulation layer 150. The color filter 160 may be disposed to correspond to each of the pixels P. For example, a red color filter RCF may be disposed to correspond to a red pixel RP, a green color filter GCF may be disposed to correspond to a green pixel GP, and a blue color filter BCF may be disposed to correspond to a blue pixel BP.

The display apparatus 100 according to an embodiment of the present disclosure may include the high refraction organic layer 152a including the plurality of light collecting structures and the low refraction organic layer 152b disposed on the high refraction organic layer 152a. Therefore, the display apparatus 100 according to an embodiment of the present disclosure may limit a light output angle of light emitted from the organic light emitting layer 130.

In more detail, the light emitted from the organic light emitting layer 130 may be refracted or reflected by the interface between the high refraction organic layer 152a and the low refraction organic layer 152b. Light incident on the interface between the high refraction organic layer 152a and the low refraction organic layer 152b may be reflected when an incident angle thereof is less than a certain angle, and thus, may not be output to the color filter 160.

The light incident on the interface between the high refraction organic layer 152a and the low refraction organic layer 152b may be refracted when the incident angle thereof is equal to or greater than the certain angle and may be transferred to the color filter 160. That is, a portion of the light emitted from the organic light emitting layer 130 may be collected, and collected light may pass through the color filter 160 and may be discharged to the outside.

As a result, the display apparatus 100 according to an embodiment of the present disclosure may include a narrow light distribution, and thus, even when an interval between the pixels P is reduced, mixing of colors may be prevented.

Moreover, in the display apparatus 100 according to an embodiment of the present disclosure, the trench T may be provided in the bank B, and the air gap AG may be provided in the trench T. In the display apparatus 100 according to an embodiment of the present disclosure, light which is reflected from the interface between the high refraction organic layer 152a and the low refraction organic layer 152b through the air gap AG provided in the trench T may again travel to the high refraction organic layer 152a. The display apparatus 100 according to an embodiment of the present disclosure may minimize the loss of the light emitted from the organic light emitting layer 130, thereby enhancing light efficiency.

Moreover, in the display apparatus 100 according to an embodiment of the present disclosure, the light collecting structure may be provided in the organic layer 152 configuring the encapsulation layer 150, and thus, light may be collected without an increase in thickness of the display apparatus 100.

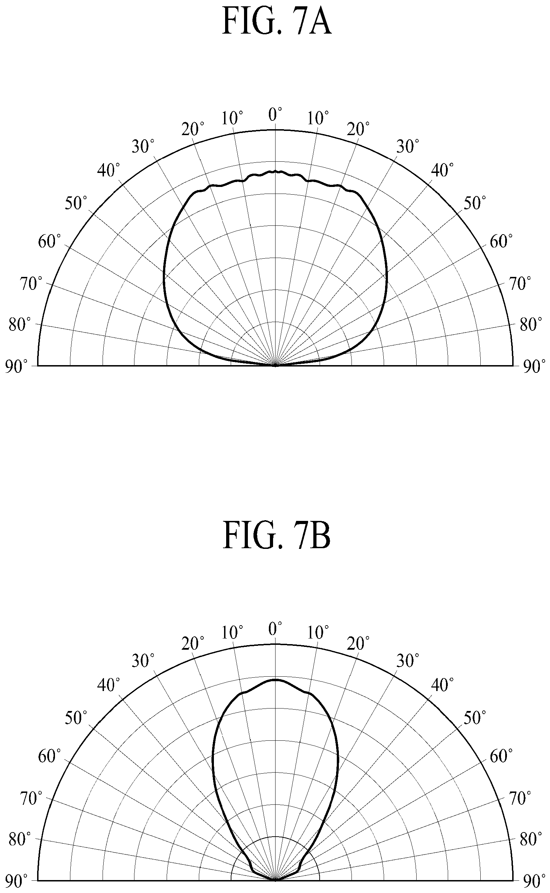

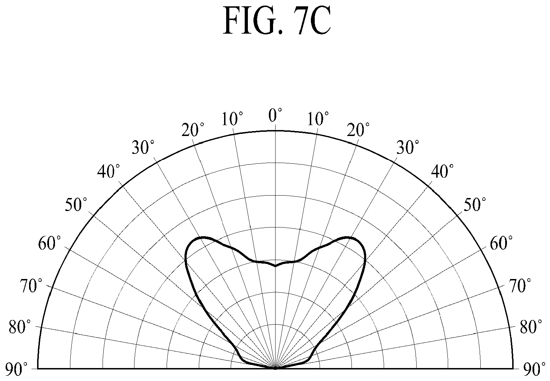

FIG. 7A is a diagram showing a light distribution of a light source to which a micro-cavity structure is not applied, FIG. 7B is a diagram showing a light distribution of a light source to which the micro-cavity structure is applied, and FIG. 7C is a diagram showing a light distribution of a light source according to an embodiment of the present disclosure.

In a light source to which the micro-cavity structure is not applied and a light source to which the micro-cavity structure is applied, the amount of light may be the maximum in 0 degrees as shown in FIGS. 7A and 7B.

In a light source according to an embodiment of the present disclosure, the micro-cavity structure may not be applied, and as shown in FIG. 7C, the amount of light may be the maximum in an angle which is greater than 0 degrees. The maximum amount of light or maximum light output may be the maximum intensity or maximum brightness of the light. In an embodiment, a light distribution may be obtained by adjusting a thickness of the organic light emitting layer 130. The organic light emitting layer 130 may have thicknesses which differ in the red pixel RP, the green pixel GP, and the blue pixel BP, based on a resonance distance where a micro-cavity is not maximized. In this case, the red pixel RP, the green pixel GP, and the blue pixel BP may differ in thickness of the organic light emitting layer 130.

In another embodiment, a light distribution may be obtained by adjusting a thickness of the first electrode 120. The first electrode 120 may have thicknesses which differ in the red pixel RP, the green pixel GP, and the blue pixel BP, based on the resonance distance where the micro-cavity is not maximized. In this case, the red pixel RP, the green pixel GP, and the blue pixel BP may differ in thickness of the first electrode 120.

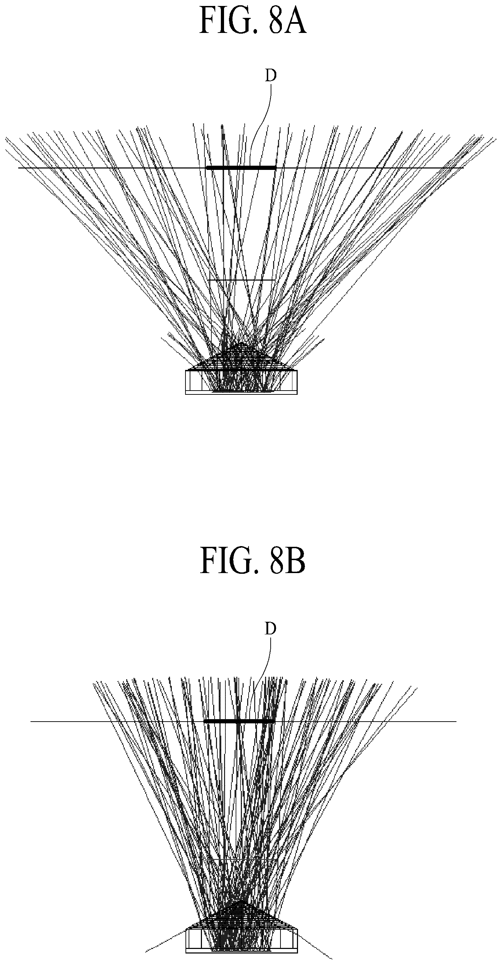

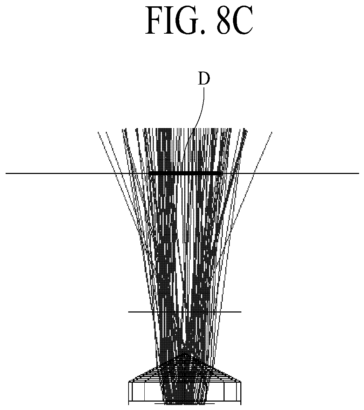

FIG. 8A is a diagram showing a simulation result of the light source of FIG. 7A, FIG. 8B is a diagram showing a simulation result of the light source of FIG. 7B, and FIG. 8C is a diagram showing a simulation result of the light source of FIG. 7C.

FIG. 8A shows a simulation result obtained by performing a simulation where the light source of FIG. 7A is applied to a portion under the organic layer 152 including the light collecting structure according to an embodiment of the present disclosure. In the simulation result, a light amount of 3.75 mW/cm² has been detected by a detection apparatus D.

FIG. 8B shows a simulation result obtained by performing a simulation where the light source of FIG. 7B is applied to the portion under the organic layer 152 including the light collecting structure according to an embodiment of the present disclosure. In the simulation result, a light amount of 4.12 mW/cm² has been detected by a detection apparatus D.

FIG. 8C shows a simulation result obtained by performing a simulation where the light source of FIG. 7C is applied to the portion under the organic layer 152 including the light collecting structure according to an embodiment of the present disclosure. In the simulation result, a light amount of 4.91 mW/cm² has been detected by a detection apparatus D.

That is, by applying a light source having a light distribution where the amount of light is the maximum in an angle of more than 0 degrees as shown in FIG. 7C, the display apparatus 100 according to an embodiment of the present disclosure may maximize a light collection effect.

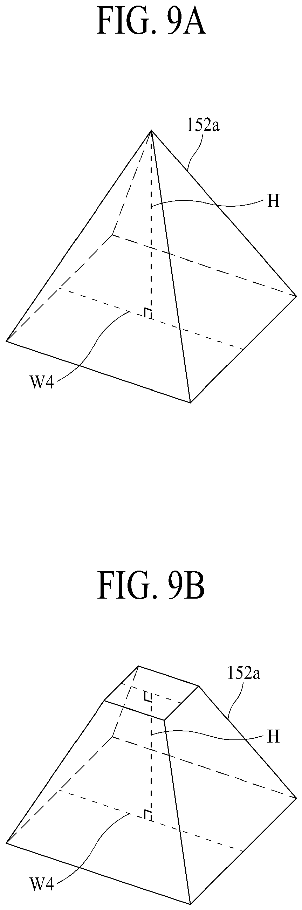

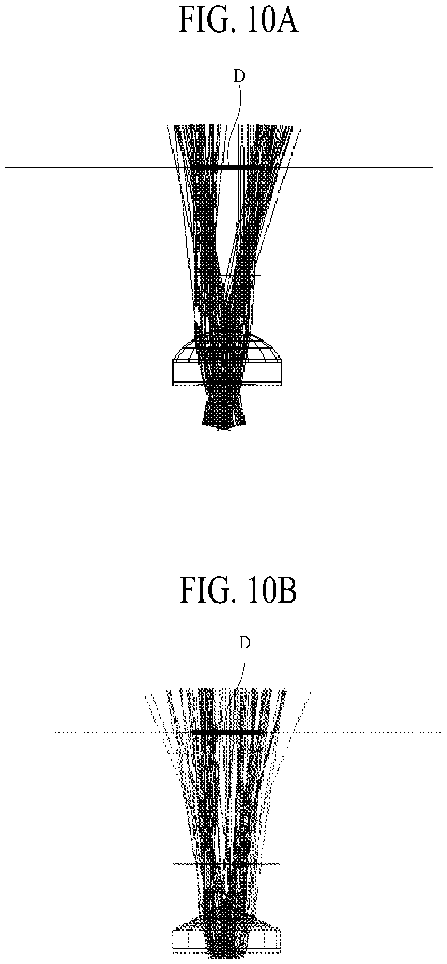

FIG. 9A is a diagram illustrating an example of a light collecting structure. FIG. 9B is a diagram illustrating another example of a light collecting structure. FIG. 10A is a diagram showing a simulation result of a light collecting structure having a hemispherical shape. FIG. 10B is a diagram showing a simulation result of a light collecting structure having a quadrangular horn shape.

The light collecting structure may have a quadrangular horn shape illustrated in FIG. 9A or a quadrangular truncated-horn shape illustrated in FIG. 9B. A height "h" of the light collecting structure may be adjusted based on a thickness of the organic layer 152 which is determined in designing a product. The height "h" of the light collecting structure may be equal to or less than the thickness of the organic layer 152. As the height "h" of the light collecting structure increases, light collection efficiency may be enhanced. Therefore, when the height "h" of the light collecting structure is set to be equal to the thickness of the organic layer 152, light collection efficiency may be maximally enhanced. However, due to a manufacturing process error, a portion of the light collecting structure may protrude without being covered by the low refraction organic layer 152b, and in this case, light collection efficiency may be reduced and Moire may occur. In order to prevent such problems, the height "h" of the light collecting structure is designed to be less than the thickness of the organic layer 152. That is, the high refraction organic layer 152a including the light collecting structure is designed to be covered by the low refraction organic layer 152b. Accordingly, light collection efficiency may be optimized, and the occurrence of Moire may be prevented.

Moreover, a width "W4" of a lower surface of the light collecting structure may be adjusted based on a width of the pixel P which is determined in designing a product. The width "W4" of the light collecting structure may be equal to or greater than the width of the pixel P. Therefore, the light collecting structure may collect light emitted from each pixel P without loss of the emitted light.

The light collecting structure according to an embodiment of the present disclosure may have a quadrangular horn shape or a quadrangular truncated-horn shape, and thus, may have a good light collection effect. FIG. 10A shows a simulation result of a light collecting structure having a hemispherical shape. In the simulation result, a light amount of 4.35 mW/cm² has been detected by a detection apparatus D. FIG. 10B shows a simulation result of a light collecting structure having a quadrangular horn shape. In the simulation result, a light amount of 4.91 mW/cm² has been detected by a detection apparatus D. That is, comparing with the light collecting structure having a hemispherical shape, the light collecting structure having a quadrangular horn shape has a good light collection effect.

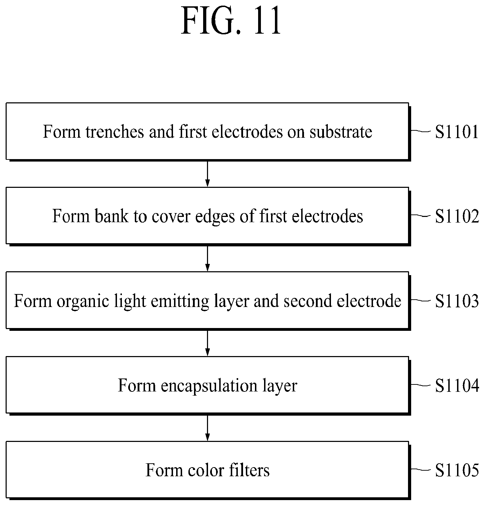

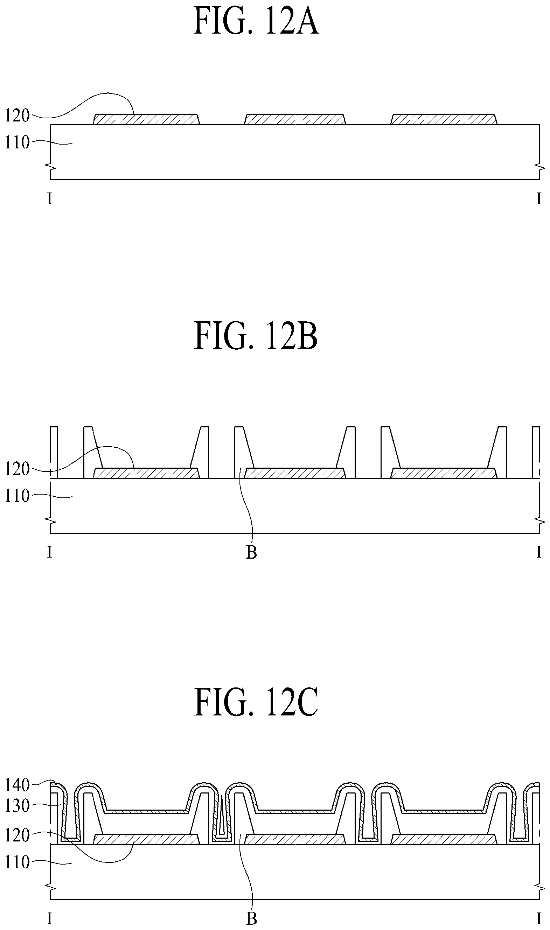

FIG. 11 is a flowchart illustrating a method of manufacturing a display apparatus according to an embodiment of the present disclosure. FIGS. 12A to 12H are cross-sectional views illustrating a method of manufacturing a display apparatus according to an embodiment of the present disclosure.

First, as in FIG. 12A, a plurality of transistors (not shown) and a plurality of first electrodes 120 may be formed on a substrate 110 (S1101).

In detail, an active layer of each of the transistors may be formed on the substrate 110. The active layer may be formed of a silicon-based semiconductor material or an oxide-based semiconductor material.

Subsequently, a gate insulation layer may be formed on the active layer. The gate insulation layer may be formed of an inorganic layer (for example, SiOx, SiNx, or a multilayer thereof).

Subsequently, a gate electrode may be formed on the gate insulation layer.

Subsequently, a first insulation layer may be formed on the active layer and the gate electrode. The first insulation layer may be formed of an inorganic layer (for example, SiOx, SiNx, or a multilayer thereof).

Subsequently, first and second contact holes connected to the active layer through the first insulation layer may be formed. A source electrode connected to the active layer through the first contact hole and a drain electrode connected to the active layer through the second contact hole may be formed on the first insulation layer.

Subsequently, the first insulation layer may be additionally formed on the source electrode and the drain electrode. A third contact hole connected to the drain electrode through the additionally formed first insulation layer may be formed. An M3 metal layer connected to the drain electrode through the third contact hole may be formed on the additionally formed first insulation layer.

Subsequently, a second insulation layer may be formed on the M3 metal layer. The second insulation layer may be formed of an inorganic layer (for example, SiOx, SiNx, or a multilayer thereof).

Subsequently, a fourth contact hole connected to an M3 metal layer through the second insulation layer may be formed. An M4 metal layer connected to the M3 metal layer through the fourth contact hole may be formed on the second insulation layer.

Subsequently, the second insulation layer may be additionally formed on the M4 metal layer. A fifth contact hole connected to the M4 metal layer through the additionally formed second insulation layer may be formed. The M3 metal layer, the M4 metal layer, and the second insulation layer may be omitted.

Subsequently, the first electrodes 120 may be formed on the substrate 110. In more detail, a first electrode layer may be formed on the second insulation layer. For example, the first electrode layer may include a metal material, which is high in reflectance, such as a stacked structure (Ti/Al/Ti) of Al and Ti, a stacked structure (ITO/Al/ITO) of Al and ITO, an APC alloy, or a stacked structure (ITO/APC/ITO) of an APC alloy and ITO. The APC alloy may be an alloy of Ag, Pd, and Cu.

Subsequently, a photoresist pattern may be formed on the first electrode layer. The photoresist pattern may be formed at a position at which pixels P are to be formed. As in FIG. 12A, the first electrodes 120 may be formed by dry-etching the first electrode layer uncovered by the photoresist pattern, and the photoresist pattern may be removed.

Subsequently, as in FIG. 12B, a bank B may be formed to cover edges of the first electrodes 120 (S1102).

In detail, a charging material may be formed on the first electrodes 120. The charging material may be an organic material (for example, acryl resin, epoxy resin, phenolic resin, polyamide resin, polyimide resin, or the like)

Subsequently, the bank B may be performed through dry-etching. A dry-etching material is capable of etching the charging material, but may be selected as a material incapable of etching the first electrodes 120.

Subsequently, a trench T may be formed in the bank B. The photoresist pattern may be formed in a region, other than a region where the trench T is to be formed, of the bank B. The trench T may be formed by etching the bank B which is exposed without being covered by the photoresist pattern, and the photoresist pattern may be removed.

Subsequently, as in FIG. 12C, an organic light emitting layer 130 and a second electrode 140 may be sequentially formed.

In detail, the organic light emitting layer 130 may be formed on the first electrodes 120 and the bank B. The organic light emitting layer 130 may be formed through a deposition process or a solution process. In a case where the organic light emitting layer 130 is formed through the deposition process, the organic light emitting layer 130 may be formed by using an evaporation process.

The organic light emitting layer 130 may be a white light emitting layer which emits white light. In this case, the organic light emitting layer 130 may be a common layer which is provided in the pixels P in common.

When the organic light emitting layer 130 is a white light emitting layer, the organic light emitting layer 130 may be provided in a tandem structure of two or more stacks. Each of the stacks may include a hole transporting layer, at least one light emitting layer, and an electron transporting layer.

Moreover, a charge generating layer may be provided between adjacent stacks. The charge generating layer may include an n-type charge generating layer, disposed adjacent to a lower stack, and a p-type charge generating layer which is provided on the n-type charge generating layer and is disposed adjacent to an upper stack. The n-type charge generating layer may inject an electron into the lower stack, and the p-type charge generating layer may inject a hole into the upper stack. The n-type charge generating layer may be formed of an organic layer doped with alkali metal such as lithium (Li), sodium (Na), potassium (K), or cesium (Cs) or alkali earth metal such as magnesium (Mg), strontium (Sr), barium (Ba), or radium (Ra). The p-type charge generating layer may be formed by doping a dopant on an organic material having an ability to transport holes.

Since the organic light emitting layer 130 is formed through the the evaporation process, the organic light emitting layer 130 may not be good in step coverage characteristic. Accordingly, the organic light emitting layer 130 may be formed not to have a constant thickness in a region where a step height occurs due to the trench T provided in the bank B.

The organic light emitting layer 130 may be formed thickly in a portion which is bent from an upper surface of the bank B to a side surface of the trench T. In more detail, a thickness of the organic light emitting layer 130 in a boundary portion between the upper surface of the bank B and a first side surface of the trench T may be set to be thicker than that of the organic light emitting layer 130 in the first side surface or a floor of the trench T. Also, a thickness of the organic light emitting layer 130 in a boundary portion between the upper surface of the bank B and a second side surface of the trench T may be set to be thicker than that of the organic light emitting layer 130 in the second side surface or the floor of the trench T. The first side surface and the second side surface of the trench T may face each other. As a result, an inner portion of the trench T may be narrowed in a direction from a lower portion to an upper portion thereof.

Moreover, a thickness of the organic light emitting layer 130 in a sidewall of the trench T provided in the bank B may be set to be thinner than that of the organic light emitting layer 130 in the floor of the trench T.

Subsequently, the second electrode 140 may be formed on the organic light emitting layer 130 (S1103). The second electrode 140 may be a common layer which is provided in the pixels P in common. The second electrode 140 may be formed of a transparent conductive material (or TCO), such as ITO or IZO, or a semi-transmissive conductive material such as magnesium (Mg), silver (Ag), or an alloy of Mg and Ag.

The second electrode 140 may be formed through a physics vapor deposition (PVD) process such as a sputtering process. A layer formed through the PVD process such as the sputtering process may be good in step coverage characteristic. Therefore, despite a step height being caused by the trench T provided in the bank B, the second electrode 140 may be deposited on the sidewall and the floor of the trench T to have a uniform thickness compared to the organic light emitting layer 130.

Subsequently, an encapsulation layer 150 may be formed on the second electrode 140 (S1104).

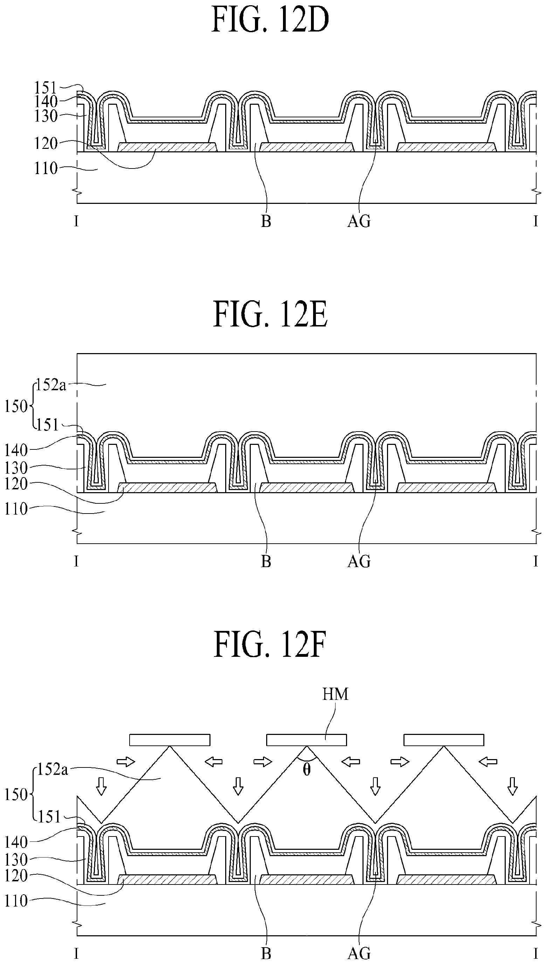

In detail, as in FIG. 12D, a first inorganic layer 151 may be formed on the first electrode 140. The first inorganic layer 151 may be formed of silicon nitride, aluminum nitride, zirconium nitride, titanium nitride, hafnium nitride, tantalum nitride, silicon oxide, aluminum oxide, or titanium oxide. The first inorganic layer 151 may be deposited through a chemical vapor deposition (CVD) process or an atomic layer deposition (ALD) process, but is not limited thereto.

Subsequently, a high refraction organic layer 152a may be formed on the first inorganic layer 151. In detail, as in FIG. 12E, a high refraction organic material having a high refractive index (for example, a refractive index of 1.7 or more) may be formed on the first inorganic layer 151. Subsequently, a hard mask HM may be disposed on the high refraction organic material, and by performing isotropic etching, the high refraction organic layer 152a may be formed as in FIG. 12F. Also, the hard mask HM may be removed.

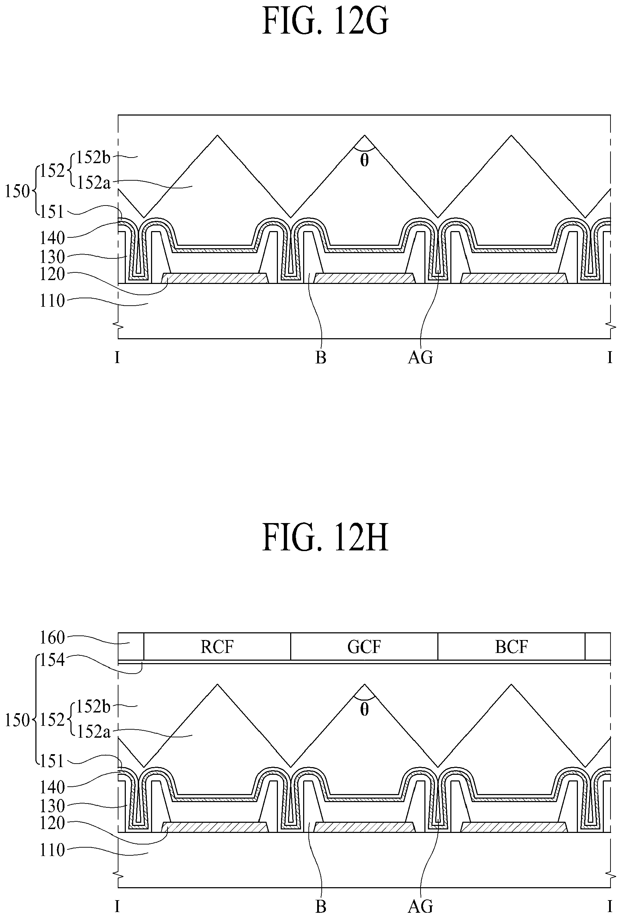

Subsequently, as in FIG. 12G, a low refraction organic layer 152b may be formed of the high refraction organic layer 152a. For example, the low refraction organic layer 152b may be formed of an organic material having a refractive index (for example, a refractive index of less than 1.7) which is less than that of the high refraction organic layer 152a. For example, the low refraction organic layer 152b may be formed of a monomer.

Subsequently, a second inorganic layer 153 may be formed on the low refraction organic layer 152b. The second inorganic layer 153 may be formed of silicon nitride, aluminum nitride, zirconium nitride, titanium nitride, hafnium nitride, tantalum nitride, silicon oxide, aluminum oxide, or titanium oxide. The second inorganic layer 153 may be deposited through a chemical vapor deposition (CVD) process or an atomic layer deposition (ALD) process, but is not limited thereto.

Subsequently, as in FIG. 12H, a color filter 160 may be formed on the encapsulation layer 150 (S1 105). The color filter 160 may be disposed to correspond to each of the pixels P. For example, a red color filter RCF may be disposed to correspond to a red pixel RP, a green color filter GCF may be disposed to correspond to a green pixel GP, and a blue color filter BCF may be disposed to correspond to a blue pixel BP. Although not shown in the drawings, an encapsulation film may be attached on the color filter 160.

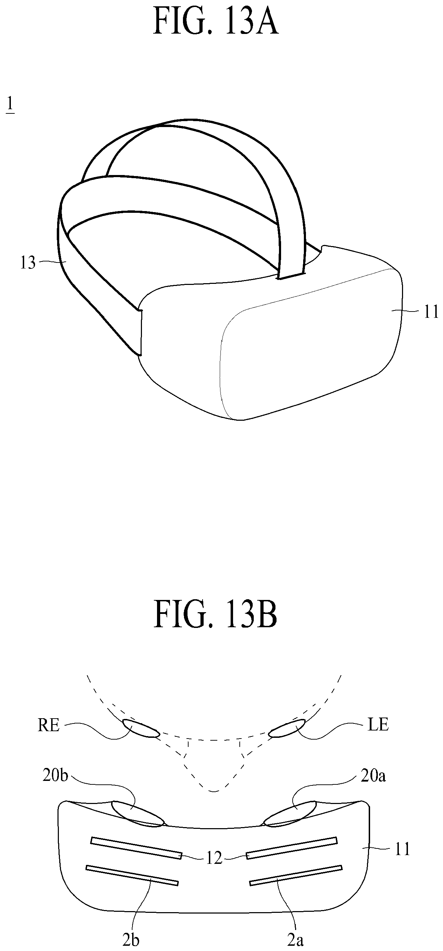

FIG. 13A is an exemplary diagram illustrating an HMD to which a display apparatus according to an embodiment of the present disclosure is applied, and FIG. 13B is an exemplary diagram illustrating an example of an accommodating case of FIG. 13A.

Referring to FIGS. 13A and 13B, an HMD 1 to which the display apparatus according to an embodiment of the present disclosure is applied may include an accommodating case 11, a left-eye lens 20a, a right-eye lens 20b, a lens array 12, and a head-mounted band 13.

The accommodating case 11 may accommodate a display panel 2 and may provide the left-eye lens 20a and the right-eye lens 20b with an image displayed by the display panel 2. The display panel 2 may be the display apparatus according to an embodiment of the present disclosure.

The accommodating case 11, as in FIG. 13B, may include a left-eye display panel 2a disposed in front of the left-eye lens 20a and a right-eye display panel 2b disposed in front of the right-eye lens 20b.

The left-eye display panel 2a and the right-eye display panel 2b may display the same image, and in this case, a user may watch a two-dimensional (2D) image. Alternatively, the left-eye display panel 2a may display a left-eye image and the right-eye display panel 2b may display a right-eye image, and in this case, the user may watch a stereoscopic image.

Each of the left-eye display panel 2a and the right-eye display panel 2b may be an organic light emitting display apparatus.

The accommodating case 11, as in FIG. 13B, may further include a lens array 12 disposed between the left-eye display panel 2a and the left-eye lens 20a and a lens array 12 disposed between the right-eye display panel 2b and the right-eye lens 20b. The lens array 12 may be a micro-lens array. The lens array 12 may be replaced by a pin hole array. By using the lens arrays 12, an image displayed by the left-eye display panel 2a or the right-eye display panel 2b may be seen as an enlarged image by the user.

A left eye LE of the user may be located in the left-eye lens 20a, and a right eye RE of the user may be located in the right-eye lens 20b. That is, each of the left-eye lens 20a and the right-eye lens 20b may correspond to an eyepiece lens disposed in front of the display panel 2.

The head-mounted band 13 may be fixed to the accommodating case 11. The head-mounted band 13 is illustrated as being provided to surround an upper surfaces and both side surfaces of a head of the user, but is not limited thereto. The head-mounted band 13 may be for fixing an HMD to the head of the user and may be provided as a glasses frame type or a helmet type.

According to the present disclosure, a high refraction organic layer including a plurality of light collecting structures is provided, and a low refraction organic layer is provided on the high refraction organic layer, thereby limiting a light output angle of light emitted from an organic light emitting layer. Accordingly, in the present disclosure, a narrow light distribution may be realized, and even when an interval between pixels is reduced, color mixture may be prevented.

Moreover, according to the present disclosure, a trench may be provided in a bank, and an air gap may be provided in the trench, thereby allowing light reflected from an interface between the high refraction organic layer and the low refraction organic layer to travel to the high refraction organic layer. Accordingly, in the present disclosure, the loss of light emitted from the organic light emitting layer may be minimized, thereby enhancing light efficiency.

Moreover, according to the present disclosure, the light collecting structure is provided in an organic layer configuring an encapsulation layer, and thus, light may be collected without an increase in a thickness of a display apparatus.

Moreover, according to the present disclosure, a light source having a light distribution where the amount of light is the maximum in an angle greater than 0 degrees may be applied, and thus, a light collection effect may be maximized.

The above-described feature, structure, and effect of the present disclosure are included in at least one embodiment of the present disclosure, but are not limited to only one embodiment. Furthermore, the feature, structure, and effect described in at least one embodiment of the present disclosure may be implemented through combination or modification of other embodiments by those skilled in the art. Therefore, content associated with the combination and modification should be construed as being within the scope of the present disclosure.

It will be apparent to those skilled in the art that various modifications and variations can be made in the present disclosure without departing from the spirit or scope of the disclosures. Thus, it is intended that the present disclosure covers the modifications and variations of this disclosure provided they come within the scope of the appended claims.

## Claims

1. A display apparatus (100) comprising:
a substrate (110) including a plurality of pixels (P), wherein each pixel of the plurality of pixels is arranged such that the maximum light output from the pixel occurs at an angle of more than 0 degrees from a line perpendicular to the pixel; and
an encapsulation layer (150) covering the plurality of pixels, the encapsulation layer including a plurality of light collecting structures each having a quadrangular horn shape or a quadrangular truncated-horn shape,
wherein the encapsulation layer comprises:
a first inorganic layer (151) provided to cover the plurality of pixels;
an organic layer (152) disposed on the first inorganic layer; and
a second inorganic layer (153) provided to cover the organic layer,
wherein the organic layer comprises:
a high refraction organic layer (152a) including the plurality of light collecting structures, wherein the plurality of light collecting structures is arranged to collect a portion of light emitted from each of the plurality of pixels; and
a low refraction organic layer (152b) disposed on the high refraction organic layer, and
wherein the height of each of the plurality of light collecting structures is less than a thickness of the organic layer (152).

2. The display apparatus of claim 1, wherein the high refraction organic layer has a first refractive index, and the low refraction organic layer has a second refractive index which is less than the first refractive index.

3. The display apparatus of claim 2, wherein the first refractive index is equal to or greater than 1.7, and the second refractive index is less than 1.7.

4. The display apparatus of any preceding claim, wherein the plurality of light collecting structures are disposed to respectively correspond to the plurality of pixels in a one-to-one relationship.

5. The display apparatus of any preceding claim, wherein each of the plurality of pixels comprises:
a plurality of first electrodes (120) disposed on the substrate;
a bank (B) provided to cover edges of the plurality of first electrodes, the bank including a trench (T);
an organic light emitting layer (130) disposed on the plurality of first electrodes and the bank; and
a second electrode (140) disposed on the organic light emitting layer.

6. The display apparatus of claim 5, wherein an air gap (AG) is provided in the trench provided in the bank.

7. The display apparatus of claim 5 or 6, wherein the organic light emitting layer is provided on each of a sidewall and a floor of the trench.

8. The display apparatus of any of claims 5-7, wherein the trench passes through the bank.

9. The display apparatus of any of claims 5-8, wherein the organic light emitting layer is a white light emitting layer which is provided in each of the plurality of pixels in common.

10. The display apparatus of any preceding claim, further comprising a color filter (160) disposed on the encapsulation layer.

11. A head-mounted display comprising:
the display apparatus of any preceding claim;
a lens array including a plurality of lenses for enlarging an image displayed by the display apparatus; and
an accommodating case accommodating the display apparatus and the lens array.

## Patentansprüche

1. Anzeigevorrichtung (100), umfassend:
ein Substrat (110), das eine Vielzahl von Pixeln (P) beinhaltet, wobei jedes Pixel der Vielzahl von Pixeln derart eingerichtet ist, dass die maximale Lichtausgabe von dem Pixel unter einem Winkel von mehr als 0 Grad von einer zu dem Pixel senkrechten Linie auftritt; und
eine Einkapselungsschicht (150), die die Vielzahl von Pixeln bedeckt, wobei die Einkapselungsschicht eine Vielzahl von lichtsammelnden Strukturen beinhaltet, die jeweils eine viereckige Horngestalt oder eine viereckige Hornstumpfgestalt aufweisen,
wobei die Einkapselungsschicht Folgendes umfasst:
eine erste anorganische Schicht (151), vorgesehen zum Abdecken der Vielzahl von Pixeln;
eine organische Schicht (152), angeordnet auf der ersten anorganischen Schicht; und
eine zweite anorganische Schicht (153), vorgesehen zum Abdecken der organischen Schicht,
wobei die organische Schicht Folgendes umfasst:
eine hochbrechende organische Schicht (152a), die die Vielzahl von lichtsammelnden Strukturen beinhaltet, wobei die Vielzahl von lichtsammelnden Strukturen eingerichtet ist zum Sammeln eines Anteils von von jedem der Vielzahl von Pixeln emittiertem Licht; und
eine niedrigbrechende organische Schicht (152b), angeordnet auf der hochbrechenden organischen Schicht, und
wobei die Höhe von jeder der Vielzahl von lichtsammelnden Strukturen kleiner als eine Dicke der organischen Schicht (152) ist.

2. Anzeigevorrichtung nach Anspruch 1, wobei die hochbrechende organische Schicht einen ersten Brechungsindex aufweist, und die niedrigbrechende organische Schicht einen zweiten Brechungsindex aufweist, der kleiner als der erste Brechungsindex ist.

3. Anzeigevorrichtung nach Anspruch 2, wobei der erste Brechungsindex größer oder gleich 1,7 ist, und der zweite Brechungsindex kleiner als 1,7 ist.

4. Anzeigevorrichtung nach einem vorhergehenden Anspruch, wobei die Vielzahl von lichtsammelnden Strukturen angeordnet ist, um der Vielzahl von Pixeln jeweils in einer eineindeutigen Beziehung zu entsprechen.

5. Anzeigevorrichtung nach einem vorhergehenden Anspruch, wobei jedes aus der Vielzahl von Pixeln umfasst:
eine Vielzahl von ersten Elektroden (120), die auf dem Substrat angeordnet ist;
eine Bank (B), vorgesehen zum Abdecken von Rändern der Vielzahl von ersten Elektroden, wobei die Bank einen Graben (T) beinhaltet;
eine organische lichtemittierende Schicht (130), angeordnet auf der Vielzahl von ersten Elektroden und der Bank; und
eine zweite Elektrode (140), angeordnet auf der organischen lichtemittierenden Schicht.

6. Anzeigevorrichtung nach Anspruch 5, wobei ein Luftspalt (AG) in dem in der Bank vorgesehenen Graben vorgesehen ist.

7. Anzeigevorrichtung nach Anspruch 5 oder 6, wobei die organische lichtemittierende Schicht auf jeder einer Seitenwand und eines Bodens des Grabens vorgesehen ist.

8. Anzeigevorrichtung nach einem der Ansprüche 5 - 7, wobei der Graben durch die Bank hindurchgeht.

9. Anzeigevorrichtung nach einem der Ansprüche 5 - 8, wobei die organische lichtemittierende Schicht eine Weißlicht emittierende Schicht ist, die gemeinsam in jedem aus der Vielzahl von Pixeln vorgesehen ist.

10. Anzeigevorrichtung nach einem vorhergehenden Anspruch, ferner umfassend ein Farbfilter (160), das auf der Einkapselungsschicht angeordnet ist.

11. Kopfmontierte Anzeige, umfassend:
die Anzeigevorrichtung nach einem vorhergehenden Anspruch;
ein Linsenarray, das eine Vielzahl von Linsen zum Vergrößern eines durch die Anzeigevorrichtung angezeigten Bilds beinhaltet; und
ein Aufnahmegehäuse, das die Anzeigevorrichtung und das Linsenarray aufnimmt.

## Revendications

1. Appareil d'affichage (100) comprenant :
un substrat (110) comportant une pluralité de pixels (P), chaque pixel de la pluralité de pixels étant agencé de telle sorte que la lumière maximale délivrée depuis le pixel apparaît à un angle de plus de 0 degré par rapport à une ligne perpendiculaire au pixel ; et
une couche d'encapsulation (150) recouvrant la pluralité de pixels, la couche d'encapsulation comportant une pluralité de structures de collecte de lumière ayant chacune une forme de corne quadrangulaire ou une forme de corne quadrangulaire tronquée,
dans lequel la couche d'encapsulation comprend :
une première couche inorganique (151) appliquée pour recouvrir la pluralité de pixels ;
une couche organique (152) disposée sur la première couche inorganique ; et
une deuxième couche inorganique (153) appliquée pour recouvrir la couche organique,
dans lequel la couche organique comprend :
une couche organique fortement réfractive (152a) comportant la pluralité de structures de collecte de lumière, la pluralité de structures de collecte de lumière étant agencée pour collecter une partie de la lumière émise depuis chacun de la pluralité de pixels ; et
une couche organique faiblement réfractive (152b) disposée sur la couche organique fortement réfractive, et
dans lequel la hauteur de chacune de la pluralité de structures de collecte de lumière est inférieure à une épaisseur de la couche organique (152).

2. Appareil d'affichage de la revendication 1, dans lequel la couche organique fortement réfractive a un premier indice de réfraction, et la couche organique faiblement réfractive a un deuxième indice de réfraction qui est inférieur au premier indice de réfraction.

3. Appareil d'affichage de la revendication 2, dans lequel le premier indice de réfraction est égal ou supérieur à 1,7, et le deuxième indice de réfraction est inférieur à 1,7.

4. Appareil d'affichage d'une quelconque revendication précédente, dans lequel la pluralité de structures de collecte de lumière sont disposées pour correspondre respectivement à la pluralité de pixels dans une relation biunivoque.

5. Appareil d'affichage d'une quelconque revendication précédente, dans lequel chacun de la pluralité de pixels comprend :
une pluralité de premières électrodes (120) disposées sur le substrat ;
un talus (B) ménagé pour recouvrir des bords de la pluralité de premières électrodes, le talus comportant une tranchée (T) ;
une couche électroluminescente organique (130) disposée sur la pluralité de premières électrodes et le talus ; et
une deuxième électrode (140) disposée sur la couche électroluminescente organique.

6. Appareil d'affichage de la revendication 5, dans lequel une lame d'air (AG) est ménagée dans la tranchée ménagée dans le talus.

7. Appareil d'affichage de la revendication 5 ou 6, dans lequel la couche électroluminescente organique est appliquée à la fois sur une paroi latérale et un fond de la tranchée.

8. Appareil d'affichage de l'une quelconque des revendications 5 à 7, dans lequel la tranchée traverse le talus.

9. Appareil d'affichage de l'une quelconque des revendications 5 à 8, dans lequel la couche électroluminescente organique est une couche émettant de la lumière blanche qui est appliquée dans chacun de la pluralité de pixels en commun.

10. Appareil d'affichage d'une quelconque revendication précédente, comprenant en outre un filtre coloré (160) disposé sur la couche d'encapsulation.

11. Visiocasque comprenant :
l'appareil d'affichage d'une quelconque revendication précédente ;
un réseau de lentilles comportant une pluralité de lentilles destinées à agrandir une image affichée par l'appareil d'affichage ; et
un boîtier d'accueil accueillant l'appareil d'affichage et le réseau de lentilles.
